# EUROPEAN PATENT APPLICATION

(11) **EP 4 847 927 A1**
(43) Date of publication of application: **02.12.2026**
(21) Application number: 25179924.3
(22) Date of filing: 30.05.2025
(51) Int. Cl.: G01R 27/28, G01R 35/00

(54) **MEASUREMENT ARRANGEMENT AND METHOD**

(71) Applicant: Bluefors Oy, 00370 Helsinki (FI)
(72) Inventor: SIMBIEROWICZ, Slawomir, 00370 Helsinki (FI)
(74) Representative: Boco IP Oy Ab

(57) **Abstract**

A measurement arrangement which comprises a vector network analyzer, a cryostat with a low-temperature region and a first electric reference unit and first switching unit which are located in the low-temperature region of the cryostat. The arrangement also comprises a first cable and a second cable which are connected to connection ports in the vector network analyzer and extend from the room-temperature environment to the low-temperature region of the cryostat. The first switching unit is configured to connect the second cable in turn to the first electric reference unit and to the first cable,

## Description

### FIELD OF THE DISCLOSURE

This disclosure relates to electric devices that are used in cryostats at low temperatures, and particularly to electric cables which connect such devices to equipment outside of the cryostat.

### BACKGROUND OF THE DISCLOSURE

Some quantum computers comprise electric hardware which is operated at low temperatures, for example around 10 mK. Electrical connections must be established between this hardware and other, room temperature control equipment which is needed to run the quantum computer. A cable which forms such connections may be exposed to temperatures which span at least four orders of magnitude, for example from 300 K to 10 mK.

Large temperature gradients can influence the electrical behaviour of a cable. Wiring arrangements have to be carefully tested before use to ensure signal integrity and facilitate impedance matching. The behaviour of electrical signals, such as microwaves of different frequency, in the wiring arrangement can then be understood. The properties of the signalling arrangement may also need to be recalibrated when the low-temperature hardware is altered.

A vector network analyzer (VNA) can be used to measure the scattering parameters of cryogenic wiring. It provides information on how signals propagate through the wiring, including magnitude and phase responses.

It is possible to study the wiring only at room temperature before it is taken into use, but this is typically not very useful since it only provides an upper bound for the losses. The wiring usually has to be characterized with measurements that involve temperature gradients similar to the ones that the cables will be exposed to in real operation.

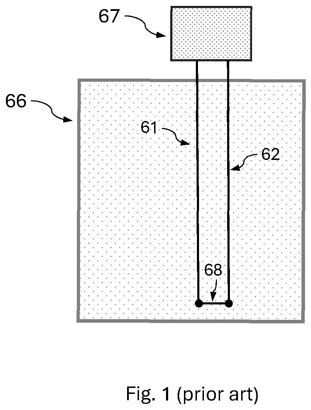

Figure 1 illustrates a measurement arrangement known from the prior art, where the properties of a cryostat wiring line 61 is studied with the help of a nominally identical line 62. Both of these cables are connected to a VNA 67, and they both extend into a cryostat 66. Inside the cryostat 66, the lines 61 and 62 are connected to each other with a short loopback cable 68. The loss measured with this arrangement may be approximately twice the one-way loss which cryostat line 61 would exhibit on its own.

However, loopback measurements have several limitations. Signal reflection in the cryostat cannot be measured at all, and signal strength will be very weak when microwave attenuation in the cryostat lines is high. The measurement may also in some cases be strongly influenced by crosstalk.

### BRIEF DESCRIPTION OF THE DISCLOSURE

An object of the present disclosure is to provide an arrangement and a method for overcoming the above problem.

The object of the disclosure is achieved by a method and an arrangement which are characterized by what is stated in the independent claims. The preferred embodiments of the disclosure are disclosed in the dependent claims.

This disclosure is based on the idea of using an electrical reference placed at a low temperature as a reference. An advantage of the method and arrangement presented in this disclosure is that signal transmission and reflection in cryostat wiring can be characterized precisely.

### BRIEF DESCRIPTION OF THE DRAWINGS

In the following the disclosure will be described in greater detail by means of preferred embodiments with reference to the accompanying drawings, in which
Figure 1 illustrates a measurement arrangement known from the prior art.
Figures 2a-2c illustrate measurement arrangements with a switching unit at low temperature.
Figure 3 illustrates a first electric reference unit.
Figures 4a - 4b illustrate measurement arrangements where more than one cable is tested.
Figure 5 illustrates a method.

### DETAILED DESCRIPTION OF THE DISCLOSURE

When characterizing cryostat signal lines, it is important to know how much of an electrical signal is transmitted, reflected or lost at different frequencies. This can be expressed with scattering parameters. Such parameters can be calculated from measurements performed by a vector network analyzer. They may for example include a return loss / reflection coefficient S₁₁ and/or a transmission coefficient S₂₁. The reference measurements and test measurements described in this disclosure may include measurements which allow these coefficients and other scattering parameters to be calculated.

This disclosure describes a measurement arrangement which comprises a vector network analyzer 17 with a first connection port 171 and a second connection port 172. The vector network analyzer 17 is in a room-temperature environment. The arrangement also comprises a cryostat 16 with a low-temperature region 161. The disclosure also comprises a first electric reference unit 51 which is located in the low-temperature region 161 of the cryostat 16.

The arrangement also comprises a first cable 11 which is connected to the first connection port 171 in the vector network analyzer 17 and extends from the room-temperature environment to the low-temperature region 161 of the cryostat 16, and a second cable 12 which is connected to the second connection port 172 in the vector network analyzer 17 and extends from the room-temperature environment to the low-temperature region 161 of the cryostat 16.

The arrangement also comprises a first switching unit 21 which is located in the low-temperature region 161 of the cryostat 16. The first electric reference unit 51, the first cable 11 and the second cable 12 may be connected to the first switching unit 21. The first switching unit 21 may be configured to connect the second cable 12 in turn to the first electric reference unit 51 and to the first cable 11.

The vector network analyzer 17 may be configured to perform one or more first reference measurements when the first switching unit 21 connects the second cable 12 to the first electric reference unit 51, and to perform at least one first test measurement when the first switching unit 21 connects the second cable 12 to the first cable 11.

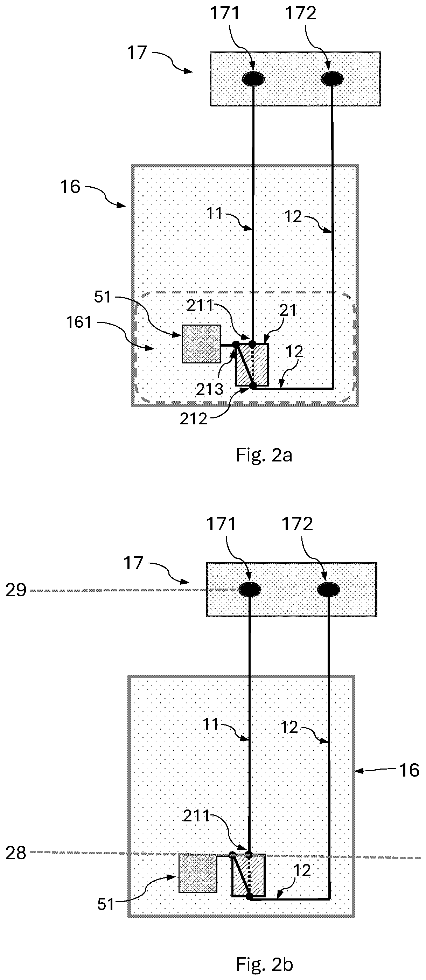

Figure 2a illustrates this arrangement. The vector network analyzer (VNA) 17 is located in a room-temperature environment. The room-temperature environment may be the space which surrounds the cryostat 16. The temperature of this environment may for example be in the range 270 - 320 K, so it is significantly higher than the temperature of the low-temperature region when the cryostat is in operation.

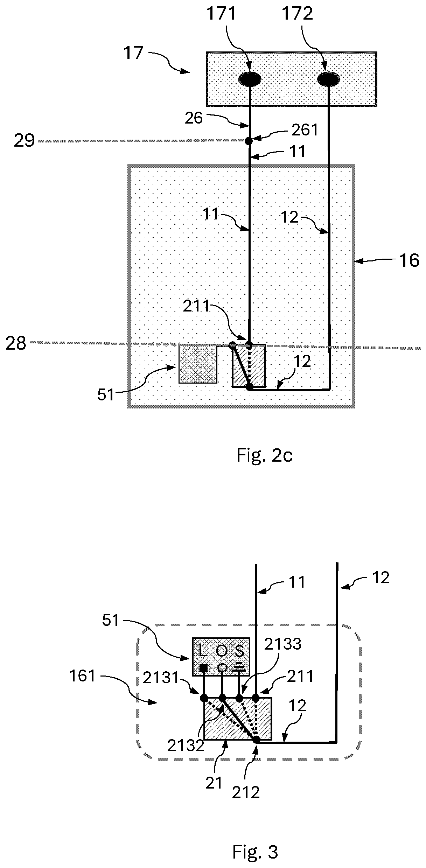

The room-temperature end of the first cable 11 may be connected directly to the first port 171, as figure 2a illustrates, so that it extends from the first port 171 to the low-temperature region 161. Similarly, the room-temperature end of the second cable 12 may be connected directly to the second port 172, so that it extends from the first port 171 to the low-temperature region 161. Alternatively, as discussed below with reference to figure 2c, the room-temperature end of the first cable 11 may be connected to the first port 171 via a connector cable 26.

The first switching unit 21 may comprise a first input/output (i/o) port 211, a second i/o port 212 and third i/o port 213, as the figure illustrates. The low-temperature end of the first cable 11 may be connected to the first i/o port 211. The second cable 12 may be connected to the second i/o port 212. The first electric reference unit 51 may be connected to the third i/o port 213. The first switching unit 21 may be connected to a switch control unit (not illustrated) which can be used to control the first switching unit 21. This switch control unit may be located at room temperature, and it may be connected to the first switching unit 21 with electric lines which are also not illustrated in figure 2a. The control unit may also be configured to control any other switching unit mentioned in this disclosure.

The switch control unit may for example be configured to toggle the first switching unit 21 between two separate states 1 and 2. In state 1, illustrated by a dotted line inside the first switching unit 21 in figure 2a, the second i/o port 212 may be connected to the first i/o port 211. In state 2, illustrated by the solid line inside the first switching unit 21 in figure 2a, i/o port 212 may be connected to the third i/o port 213. In other words, the first switching unit 21 may be configured to connect the second cable 12 in turn to the first electric reference unit 51 and to the first cable 11.

If the first electric reference unit 51 comprises multiple standards, then the first switching unit 21 may comprise a separate i/o port for each standard, as figure 3 illustrates, and the first switching unit 21 may be configured to connect the second cable 12 in turn to the first i/o port 211 and to each of the i/o ports which lead to the first electric reference unit 51. This option will be discussed in more detail below.

The switching unit may also comprise one or more additional i/o ports (not illustrated) where additional cables-of-interest (similar to cable 11) could be connected for testing. The arrangement could therefore be used to measure the scattering parameters of several cables-of-interest in quick succession. However, the switching unit should preferably consume little current, so that it emits very little heat. The number of ports and the number and frequency of port-to-port switches may therefore have to be optimized based on the heat-emission properties of the switching unit. Any switching unit described in this disclosure may for example be a latching mechanical relay.

Any cable described in this disclosure may for example be a coaxial cable. Each connection port in the vector network analyzer may be configured to receive a coaxial cable. However, other cables may also be used. Any cable described in this disclosure may be a flexible cable, but the arrangements may alternatively be used for measuring rigid cables.

Any cable described in this disclosure may be a part of bundle of cables. In other words, it may lie adjacent to tens or hundreds of similar cables which are protected by a common sheath.

Any cable or bundle of cables described in this disclosure may extend from the room-temperature environment which surrounds the cryostat 16 to the inside of the cryostat and to the low-temperature region 161.

Each electric reference unit described in this disclosure may comprise one or more microwave calibration standards. Each microwave calibration standard may be a device which establishes a reference for accurate measurements in microwave and RF (radio frequency) testing. Standards help correct systematic errors and improve the accuracy of scattering parameter measurements by defining known electrical properties.

The first electric reference unit 51 may, but does not necessarily have to, comprise a casing where the one or more microwave calibration standards are located. However, the one or more microwave calibration standards may alternatively be separate devices without a common casing, and in this case the first electric reference unit 51 refers to this group of devices.

Each electric reference unit may comprise one or more impedance standards. These impedance standards may for example comprise a precisely defined short circuit (S) with a known electrical delay, an open circuit (O) with known fringe capacitance, and/or a precision matched impedance load (L) to terminate the port with minimal reflections. The magnitude of the load impedance may for example be 50 ohms, but other values, for example 75 ohms, are also possible.

The electric reference unit may be calibrated at room temperature, and it may comprise components whose electrical properties do not change, or change very little, at cryogenic temperatures like the temperature in the low-temperature region 161. Alternatively, the electric reference unit may be calibrated at the temperature at which the low-temperature region will be when the measurements described in this disclosure are to be carried out. In other words, one or more electrical properties of the electric reference unit may be determined at cryogenic temperatures before the measurements described in this disclosure are carried out. Either way, the electrical properties of the electric reference unit at the temperature of the low-temperature region are known.

The electric reference units described in this disclosure may comprise just one or two of the three impedance standards (L, O, S), without comprising the others. In other words, it may be sufficient for some purposes to perform the one or more reference measurements with connections to only some of these impedance standards.

Alternatively, as described in more detail below, any electric reference unit described in this disclosure may comprise all three of the impedance standards listed above (L, O, S). The one or more reference measurements may then comprise a separate measurement for all three standards.

The low-temperature region 161 of the cryostat 16 may for example be at a temperature which is below 1 K, below 100 mK or below 10 mK. Alternatively, the temperature of the low-temperature region may be in the range 65-85 K in the range 45-55 K or in the range 3-8 K.

This temperature may correspond to the temperature at which the first cable 11 will be used after testing. The first electric reference unit 51, and other reference units which are placed in the low-temperature region 161, each impedance standard may for example comprise an SMA-connector (subminiature version A) for receiving a coaxial RF cable.

In any embodiment presented in this disclosure, the first cable may comprise an electrical connection in a printed circuit, and the printed circuit may be located fully or partly within the cryostat 16. In other words, the printed circuit may either be located fully within the cryostat and connected to a connector cable, such as cable 26 in figure 2c, inside the cryostat. Alternatively, the printed circuit may extend from the room-temperature environment to the low-temperature region. In the latter case, the printed circuit may be connected to a connector cable, such as arrangement 26 in figure 2c, in the room temperature environment.

The first cable 11 may for example be a flexible cable. The first cable 11 may form a part of a printed circuit (not illustrated). The measurement arrangement may comprise a printed circuit which extends between the room-temperature environment and the low-temperature region. This printed circuit may comprise several electrical connections which extend from the room temperature environment to the low-temperature region. One of these connections may be the first cable 11, or it may form a part of the first cable 11. Optionally, the first cable 11 may also comprise breakout connectors which extend away from the printed circuit at one or both of the room-temperature and low-temperature ends of the printed circuit. These breakout connectors may facilitate easier assembly and connection at both ends of the printed circuit. The printed circuit may be a flexible printed circuit. In other words, the printed circuit may have been formed on a flexible substrate. The third cable 13, discussed below, may be the same kind of cable as the first cable 11.

The second cable 12 may be, but does not necessarily have to be, a coaxial cable.

As mentioned earlier, the vector network analyzer 17 may be configured to perform one or more first reference measurements when the first switching unit 21 connects the second cable 12 to the first electric reference unit 51, and a first test measurement when the first switching unit 21 connects the second cable 12 to the first cable 11. Each first reference measurement may be performed when the second cable 12 is connected to one of the impedance standards in the first electric reference unit 51. The properties of the second cable 12 may be determined in the one or more first reference measurements, while the combined properties of both the first cable 11 and the second cable 12 may be determined in the one or more first test measurements.

The vector network analyzer 17, or the control unit described below, may be configured to calculate, with the help of the data gathered in the first test measurements and the first reference measurement, the scattering parameters of the first cable 11. As discussed in more detail below, the first cable 11 may effectively be used as a so-called unknown-thru standard in this procedure.

Clearly, the second cable 12 will be included in every measurement. However, with the help of the result of the reference measurements, the contribution which the second cable 12 makes to the test measurement can be eliminated. The control unit or the vector network analyzer may be configured to perform calculations where the contribution of the second cable 12 is eliminated from the scattering parameter results.

Optionally, a further reference measurement, where first cable 11 is temporarily replaced with a first reference cable (not illustrated), and the first switching unit 21 connects the second cable 12 to the reference cable while the network analyzer 17 performs a measurement, may also be performed. The reference cable functions as the unknown thru in this further reference measurement.

A first reference plane 28 for the test measurement may lie at the first i/o port 211. A second reference plane 29 may lie at the first connection port 171 of the vector network analyzer 17 if the first cable 11 is connected directly to the first connection port 171. This is illustrated in figure 2b.

Figure 2c illustrates an embodiment where a connector cable 26, which lies entirely at room temperature, is connected between the room-temperature end of the first cable 11 and the first connection port 171. The properties of the connector cable 26 at room temperature are well-known. The connector cable 26 is connected between the first connection port 171 and the first cable 11 at a connection point 261. The free end of the connector cable 26 (the end which is connected to the first cable 11 at connection point 261) may form the second reference plane 29. The first reference plane 28 is still at the first i/o port 211. The connector cable 26 may comprise just a single cable or alternatively a more complicated arrangement.

An additional connector cable (not illustrated) may extend between the room-temperature end of the second cable 12 and the second connection port 172. Similarly, connector cables may also be placed between the VNA and the room-temperature end of any other cable which extends from the room-temperature environment to the low-temperature region.

In both figures 2b and 2c, only the first cable 11 lies between the two reference planes 28 and 29. The vector network analyzer 17 can be configured to perform calculations to eliminate from the scattering parameter output the contributions of all circuit elements which do not lie between the first and second reference planes.

Additional reference measurements may optionally be conducted at the first connection port 171 at room temperature, and the results of these measurements may also be taken into account when the scattering parameters are calculated. This is described in more detail below, where a measurement method is presented. The measurement arrangement may optionally comprise an additional electric reference unit at room temperature. The first connection port 171 in the vector network analyzer 17 may be connected to this additional electric reference unit when the additional reference measurements are performed.

Optionally, the first electric reference unit (51) may comprise a first short-circuit standard (S), a first open-circuit standard (O) and a first load standard (L). The one or more first reference measurements may comprise one measurement which the vector network analyzer (17) is configured to perform when the first switching unit (21) connects the second cable (12) to the first short-circuit standard (S), one measurement which the vector network analyzer (17) is configured to perform when the first switching unit (21) connects the second cable (12) to the first open-circuit standard (O), and one measurement which the vector network analyzer (17) is configured to perform when the first switching unit (21) connects the second cable (12) to the first load standard (L).

Figure 3 illustrates a first electric reference unit 51 which comprises all three standards L, O and S mentioned above. The first switching unit 21 may in this case comprise a Load i/o port 2131 which is connected to the load standard L, an Open i/o port 2132 which is connected to the open-circuit standard O and a Short i/o port 2133 which is connected to the short-circuit standard S in the first electric reference unit 51.

In figure 3 the switch control unit may for example be configured to toggle the first switching unit 21 between four separate states 1-4. In state 1, illustrated by a dotted line inside the first switching unit 21 in figure 3, the second i/o port 212 may be connected to the first i/o port 211. In state 2, also illustrated by a dotted line, i/o port 212 may be connected to the Short i/o port 2133. In state 3, illustrated by the solid line, i/o port 212 may be connected to the Open i/o port 2132. In state 4, illustrated by another dotted line, i/o port 212 may be connected to the Load i/o port 2131. These states could be connected in any order, for example 1-2-3-4 with 1 being the first, or 2-3-4-1 with 2 being the first.

In other words, the first switching unit 21 may be configured to connect the second cable 12 in turn to the first electric reference unit 51 and to the first cable 11.

The arrangement may comprise a control unit (not illustrated) which is configured to control both the vector network analyzer 17 and the first switching unit 21. The switch control unit may be a part of the control unit. The control unit may comprise a computer and a processor which is configured to execute a control program on the computer. The control unit may be connected to the vector network analyzer and the switching unit(s) with electrical connections. The control unit may be configured to transmit and receive electrical control signals to and from the vector network analyzer and the switching unit(s).

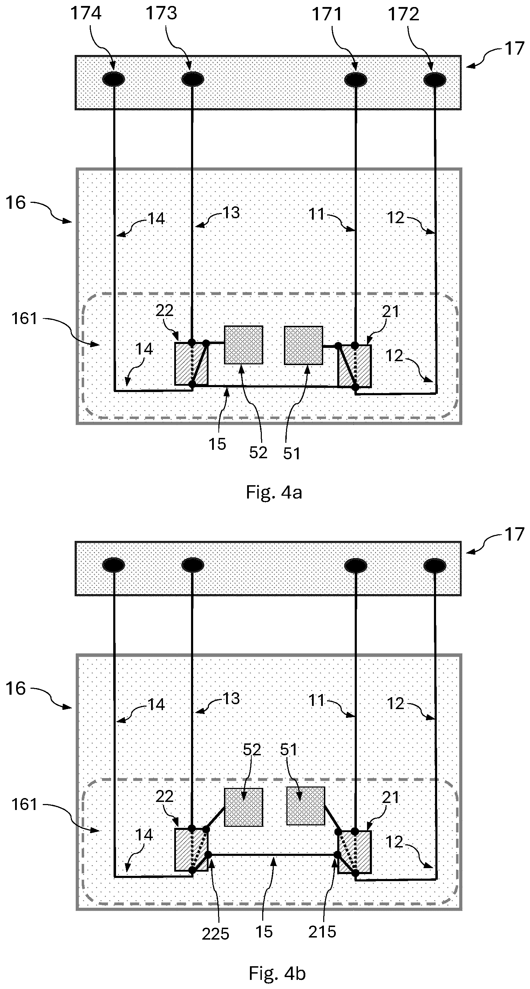

The measurement arrangement may optionally be expanded to a configuration where more than one cables can be tested. This is illustrated in figures 4a - 4b, where there are two cables of interest: the first cable 11 and a third cable 13.

Figure 4a illustrates a measurement arrangement where the vector network analyzer 17 also comprises a third connection port 173 and a fourth connection port 174. The arrangement also comprises a second electric reference unit 52 which is located in the low-temperature region 161 of the cryostat 16. It also comprises a third cable 13 which is connected to the third connection port 173 in the vector network analyzer 17 and extends from the room-temperature environment to the low-temperature region 161 of the cryostat 16, and a fourth cable 14 which is connected to the fourth connection port 174 in the vector network analyzer 17 and extends from the room-temperature environment to the low-temperature region 161 of the cryostat 16.

The arrangement in figure 4a also comprises a second switching unit 22 which may be located in the low-temperature region 161 of the cryostat 16. The second electric reference unit 52, the third cable 13 and the fourth cable 14 are connected to the second switching unit 22. The arrangement also comprises a fifth cable 15 which extends from the first switching unit 21 to the second switching unit 22.

The second switching unit 22 may be configured to connect the fourth cable 14 in turn to the second electric reference unit 52 and to the third cable 13. The vector network analyzer 17 is configured to perform one or more second reference measurements when the second switching unit 22 connects the fourth cable 14 to the second electric reference unit 52, and to perform at least one second test measurement when the second switching unit 22 connects the fourth cable 14 to the third cable 13, and to perform at least one third reference measurement when the first switching unit 21 connects the first cable 11 to the second cable 12 and the second cable 12 is connected to the fourth cable 14 via the fifth cable 15.

All options described in this disclosure relating to the first reference measurements and to the first test measurement apply also to the second reference measurements and the second test measurement. The scattering properties of the third cable 13 can thereby be determined.

A further reference measurement, similar to the further reference measurement described above, may also be performed by replacing the third cable 13 temporarily with a second reference cable (this option is not illustrated).

The fifth cable 15 may couple the second switching unit 22 to the first switching unit 21 and form a third unkown. In other words, the first and second switching units may comprise a switch configuration which allows the second cable 12 to be connected to the fourth cable 14 via the fifth cable 15. The third reference measurement together with the first and second reference measurements may allow the crosstalk between third cable 13 and first cable 11 to be determined during the test measurements.

Figure 4a illustrates an embodiment where the fifth cable extends between the second i/o ports 212 of the first (21) and second (22) switching units. In this embodiment, the first (21) and second (22) switching units may in the third reference measurement be set to an "off" state where neither the first and third cables 11 and 13 nor the first and electric reference units 51 and 52 are connected to either of the second (12) and fourth (14) cables. The second (12) and fourth (14) cables will then only be connected to each other via the fifth cable 15. The fifth cable is the third unknown thru in this arrangement (in addition to the first and third cables 11 and 13, and/or the first and second reference cables).

Figure 4b illustrates an alternative embodiment where the fifth cable extends between additional i/o ports 215 and 225 on the first and second switching units 21 and 22, respectively. In this embodiment, the first (21) and second (22) switching units may in the third reference measurement both be set to the additional i/o ports 215 and 225, as figure 4b illustrates. Again, this yields an arrangement where neither the first and third cables 11 and 13 nor the first and electric reference units 51 and 52 are connected to either of the second (12) and fourth (14) cables. Instead, as in figure 4a, the second (12) and fourth (14) cables are only connected to each other via the fifth cable 15 and the third reference measurement can be performed.

All options presented above relating to first cable 11 apply also to the third cable 13. All options presented above relating to second cable 12 apply also to the fourth cable 14. If the first cable 11 forms a part of a printed circuit, then the third cable 13 may (but does not necessarily have to) be a part of the same printed circuit.

All options presented above relating to first switching unit 21 and the first electric reference unit 51 apply also to the second switching unit 22 and the second electric reference unit 52, respectively. In particular, the details shown in figure 3 could also be implemented on the left side of figure 4a. In other words, the second electric reference unit may comprise a second short-circuit standard (S), a second open-circuit standard (O) and a second load standard (L), and the one or more second reference measurements may comprise one measurement which the vector network analyzer is configured to perform when the second switching unit connects the fourth cable to the second short-circuit standard (S), one measurement which the vector network analyzer is configured to perform when the second switching unit connects the fourth cable to the second open-circuit standard (O), and one measurement which the vector network analyzer is configured to perform when the second switching unit connects the fourth cable to the second load standard (L).

Optionally, each of the first (11) and third (13) cables may comprise an electrical connection in a printed circuit, and said printed circuit may be at least partly located within the cryostat 16.

In other words, if the first cable 11 forms a part of a printed circuit as described above, then the third cable 13 may comprise an electrical connection in the same printed circuit. The two cables may in this case comprise parts which extend from the room-temperature environment to the low-temperature region on the same printed circuit. These parts may be parallel in the printed circuit.

Alternatively, the first cable 11 and third cable 13 may be parts of a more complex cabling arrangement which comprises multiple printed circuits, and the third cable 13 may comprise an electrical connection in a printed circuit which is different from the printed circuit where the first cable 11 is located. Both of these printed circuits may be formed on flexible substrates. These substrates may be substantially parallel to each other.

Optionally the first (11) and third (13) cables may lie in the same cable bundle.

This disclosure also presents a measurement method. The method may comprise providing a vector network analyzer 17 with a first connection port 171 and a second connection port 172 in a room-temperature environment. The method may also comprise providing a cryostat 16 with a low-temperature region 161, and providing a first electric reference unit 51 which is located in the low-temperature region 161 of the cryostat 16.

The method may also comprise providing a first cable 11 which is connected to the first connection port 171 in the vector network analyzer 17 and extends from the room-temperature environment to the low-temperature region 161 of the cryostat 16 and providing a second cable 12 which is connected to the second connection port 172 in the vector network analyzer 17 and extends from the room-temperature environment to the low-temperature region 161 of the cryostat 16.

The method may also comprise providing a first switching unit 21 which is located in the low-temperature region 161 of the cryostat 16 and connecting the first electric reference unit 51, the first cable 11 and the second cable 12 to the first switching unit 21.

The method may further comprise connecting, through the first switching unit 21, the second cable 12 in turn to the first electric reference unit 51 and to the first cable 11. The method may comprise performing, with the vector network analyzer 17, one or more first reference measurements when the second cable 12 is connected to the first electric reference unit 51 via the first switching unit 21, and performing, with the vector network analyzer 17, at least one first test measurement when the second cable 12 is connected to the first cable 11 via the first switching unit 21.

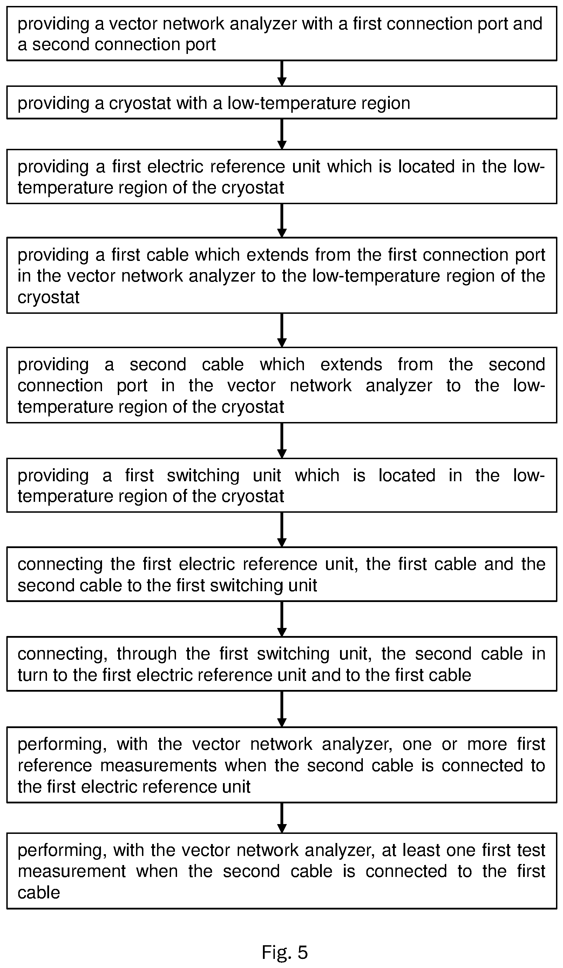

This method is illustrated in figure 5. The method may further comprise calculating, based on the at least one first test measurement and the one or more first reference measurements, one or more scattering parameters which are characteristic of the first cable 11 when one of its ends is at room temperature and the other at the temperature of the low-temperature region 161. These scattering parameters may for example include a return loss / reflection coefficient S₁₁ and/or a transmission coefficient S₂₁.

As indicated previously, the first electric reference unit may optionally comprise a first short-circuit standard (S), a first open-circuit standard (O) and a first load standard (L). Performing the one or more first reference measurements may then comprise performing at least one measurement when the second cable is connected to the first short-circuit standard (S) through the first switching unit, performing at least one measurement when the second cable is connected to the first open-circuit standard (O) through the first switching unit, and performing at least one measurement when the second cable is connected to the first load standard (L) through the first switching unit.

The method may comprise performing an "unknown thru" calibration as a part of a SOLT (short-open-load-thru) calibration. The first cable 11, which extends to the low-temperature region 161, is treated as the unknown thru in the calibration.

Optionally, the method may also comprise providing a first additional electric reference unit which is located outside of the cryostat, connecting the additional electric reference unit to the first connection port, and performing, with the vector network analyzer, one or more additional first reference measurements when the additional electric reference unit is connected to the first connection port.

The first additional electric reference unit may be at room temperature, and it may for example be an electronic calibration kit (Ecal). The first additional electric reference unit may comprise the same impedance standards S, O and L which are present in the first electric reference unit 51 located in the cryostat 16. In other words, the magnitude of the load impedance L and other electric properties of the S, O and L standards may be equal in the first electric reference unit 51 and in the first additional electric reference unit.

The first additional electric reference unit may be used to perform a one-port calibration of the first connection port 171 either before or after the first (and optionally second) test measurements and before or after the first (and optionally second) reference measurements. This one-port calibration may be a SOL-calibration.

In the measurement configuration illustrated in figure 2b, the calibration may be performed by connecting the first additional electric reference unit directly to the first connection port 171. In the measurement configuration illustrated in figure 2c, on the other hand, the calibration may be performed by connecting the first additional electric reference unit to the free end of the connector cable 26.

The method may optionally comprise including the additional first reference measurements in the calculation where the scattering parameters of the first cable 11 are calculated.

However, the one-port calibration does not necessarily have to performed in conjunction with the first (or second) test/reference measurements. The vector network analyzer 17 or the control unit could alternatively use one-port calibration data obtained at some earlier time in the calculation of the scattering parameters of the first cable 11 (and optionally the third cable 13).

The first reference measurements and the additional first reference measurements may, in effect, be two 1-port calibrations which are conducted at the opposite ends of the first cable 11. The first cable 11 can then itself be used as the unknown thru (T) standard for a two-port calibration between the first (171) and the second (172) connection ports.

Furthermore, when the vector network analyzer comprises a third connection port and a fourth connection port, the method may comprise providing a second electric reference unit which is located in the low-temperature region of the cryostat, providing a third cable which is connected to the third connection port in the vector network analyzer and extends from the room-temperature environment to the low-temperature region of the cryostat, and providing a fourth cable which is connected to the fourth connection port in the vector network analyzer and extends from the room-temperature environment to the low-temperature region of the cryostat.

The method may then also comprise providing a fifth cable which extends from the first switching unit to the second switching unit, providing a second switching unit which is located in the low-temperature region of the cryostat, connecting the second electric reference unit, the third cable and the fourth cable to the second switching unit, and connecting, through the second switching unit, the fourth cable in turn to the second electric reference unit and to the third cable. The method may then also comprise performing, with the vector network analyzer, one or more second reference measurements when the fourth cable is connected to the second electric reference unit, and performing with the vector network analyzer, at least one second test measurement when the fourth cable is connected to the third cable. The method also comprises performing, with the vector network analyzer, at least one third reference measurement when the second cable 12 is connected to the fourth cable 14 via the fifth cable 15.

All options described above relating to the method performed with the first switching unit can also be used in the method which is performed with the second switching unit.

When the second electric reference unit comprises a second short-circuit standard (S), a second open-circuit standard (O) and a second load standard (L), performing the one or more second reference measurements may comprises performing one measurement when the fourth cable is connected to the second short-circuit standard (S) through the second switching unit, performing one measurement when the fourth cable is connected to the second open-circuit standard (O) through the second switching unit, and performing one measurement when the fourth cable is connected to the second load standard (L) through the second switching unit.

The method may then also comprise providing a second additional electric reference unit which is located outside of the cryostat, connecting the additional second electric reference unit to the third connection port, and performing, with the vector network analyzer, one or more additional second reference measurements when the additional second electric reference unit is connected to the second connection port.

The second additional electric reference unit may be the same electric reference unit as the first additional electric reference unit. All options described above with reference to the first additional electric reference unit apply also to the second additional electric reference unit.

The method may be performed by the control unit. In other words, a computer system may be configured to perform any of the methods presented above. The computer may execute a computer program product comprising instructions which, when executed by the computer, cause the computer to perform any method described above.

## Claims

1. A measurement arrangement which comprises:
- a vector network analyzer (17) with a first connection port (171) and a second connection port (172), wherein the vector network analyzer (17) is in a room-temperature environment,
- a cryostat (16) with a low-temperature region (161),
- a first electric reference unit (51) which is located in the low-temperature region (161) of the cryostat (16),
- a first cable (11) which is connected to the first connection port (171) in the vector network analyzer (17) and extends from the room-temperature environment to the low-temperature region (161) of the cryostat (16),
- a second cable (12) which is connected to the second connection port (172) in the vector network analyzer (17) and extends from the room-temperature environment to the low-temperature region (161) of the cryostat (16),
**characterized in that**
- the arrangement also comprises a first switching unit (21) which is located in the low-temperature region (161) of the cryostat (16),
- the first electric reference unit (51), the first cable (11) and the second cable (12) are connected to the first switching unit (21), and
- the first switching unit (21) is configured to connect the second cable (12) in turn to the first electric reference unit (51) and to the first cable (11), and
- the vector network analyzer (17) is configured to perform one or more first reference measurements when the first switching unit (21) connects the second cable (12) to the first electric reference unit (51), and to perform at least one first test measurement when the first switching unit (21) connects the second cable (12) to the first cable (11).

2. A measurement arrangement according to claim 1, wherein the first electric reference unit (51) comprises a first short-circuit standard (S), a first open-circuit standard (O) and a first load standard (L), and the one or more first reference measurements comprise one measurement which the vector network analyzer (17) is configured to perform when the first switching unit (21) connects the second cable (12) to the first short-circuit standard (S), one measurement which the vector network analyzer (17) is configured to perform when the first switching unit (21) connects the second cable (12) to the first open-circuit standard (O), and one measurement which the vector network analyzer (17) is configured to perform when the first switching unit (21) connects the second cable (12) to the first load standard (L).

3. A measurement arrangement according to any of claims 1-2, wherein the first cable comprises an electrical connection in a printed circuit, and the printed circuit is at least partly located within the cryostat.

4. A measurement arrangement according to any of claims 1-3, wherein the vector network analyzer (17) also comprises a third connection port (173) and a fourth connection port (174), and the arrangement also comprises
- a second electric reference unit (52) which is located in the low-temperature region (161) of the cryostat (16),
- a third cable (13) which is connected to the third connection port (173) in the vector network analyzer (17) and extends from the room-temperature environment to the low-temperature region (161) of the cryostat (16),
- a fourth cable (14) which is connected to the fourth connection port (174) in the vector network analyzer (17) and extends from the room-temperature environment to the low-temperature region (161) of the cryostat (16),
- whereinthe arrangement also comprises a second switching unit (22) which is located in the low-temperature region (161) of the cryostat (16),
- the second electric reference unit (52), the third cable (13) and the fourth cable (14) are connected to the second switching unit (22), and
- the arrangement also comprises a fifth cable (15) which extends from the first switching unit (21) to the second switching unit (22), and
- the second switching unit (22) is configured to connect the fourth cable (14) in turn to the second electric reference unit (52) and to the third cable (13), and
- the vector network analyzer (17) is configured to perform one or more second reference measurements when the second switching unit (22) connects the fourth cable (14) to the second electric reference unit (52), and to perform at least one second test measurement when the second switching unit (22) connects the fourth cable (14) to the third cable (13), and to perform at least one third reference measurement when the second cable (12) is connected to the fourth cable (14) via the fifth cable (15).

5. A measurement arrangement according to claim 4, wherein the second electric reference unit comprises a second short-circuit standard (S), a second open-circuit standard (O) and a second load standard (L), and the one or more second reference measurements comprise one measurement which the vector network analyzer is configured to perform when the second switching unit connects the fourth cable to the second short-circuit standard (S), one measurement which the vector network analyzer is configured to perform when the second switching unit connects the fourth cable to the second open-circuit standard (O), and one measurement which the vector network analyzer is configured to perform when the second switching unit connects the fourth cable to the second load standard (L).

6. A measurement arrangement according to any of claims 4-5, where each of the first (11) and third (13) cables comprises an electrical connection in a printed circuit, and said printed circuit is at least partly located within the cryostat.

7. A measurement method comprising:
- providing a vector network analyzer with a first connection port and a second connection port in a room-temperature environment,
- providing a cryostat with a low-temperature region,
- providing a first electric reference unit which is located in the low-temperature region of the cryostat,
- providing a first cable which is connected to the first connection port in the vector network analyzer and extends from the room-temperature environment to the low-temperature region of the cryostat,
- providing a second cable which is connected to the second connection port in the vector network analyzer and extends from the room-temperature environment to the low-temperature region of the cryostat,
**characterized in that** the method also comprises
- providing a first switching unit which is located in the low-temperature region of the cryostat,
- connecting the first electric reference unit, the first cable and the second cable to the first switching unit, and
- connecting, through the first switching unit, the second cable in turn to the first electric reference unit and to the first cable, and
- performing, with the vector network analyzer, one or more first reference measurements when the second cable is connected to the first electric reference unit via the first switching unit,
- performing, with the vector network analyzer, at least one first test measurement when the second cable is connected to the first cable via the first switching unit.

8. A method according to claim 7, wherein the first electric reference unit comprises a first short-circuit standard (S), a first open-circuit standard (O) and a first load standard (L), and performing the one or more first reference measurements comprises:
- performing at least one measurement when the second cable is connected to the first short-circuit standard (S) through the first switching unit,
- performing at least one measurement when the second cable is connected to the first open-circuit standard (O) through the first switching unit, and
- performing at least one measurement when the second cable is connected to the first load standard (L) through the first switching unit.

9. A method according to any of claims 7-8, wherein the first cable comprises an electrical connection in a printed circuit, and the printed circuit is at least partly located within the cryostat.

10. A method according to any of claims 7-9, wherein the method also comprises
- providing a first additional electric reference unit which is located outside of the cryostat,
- connecting the additional electric reference unit to the first connection port, and
- performing, with the vector network analyzer, one or more additional first reference measurements when the additional electric reference unit is connected to the first connection port.

11. A method according to any of claims 7-10 wherein the vector network analyzer also comprises a third connection port and a fourth connection port, and the method comprises
- providing a second electric reference unit which is located in the low-temperature region of the cryostat,
- providing a third cable which is connected to the third connection port in the vector network analyzer and extends from the room-temperature environment to the low-temperature region of the cryostat,
- providing a fourth cable which is connected to the fourth connection port in the vector network analyzer and extends from the room-temperature environment to the low-temperature region of the cryostat,
wherein the method also comprises
- providing a fifth cable (15) which extends from the first switching unit (21) to the second switching unit (22),
- providing a second switching unit which is located in the low-temperature region of the cryostat,
- connecting the second electric reference unit, the third cable and the fourth cable to the second switching unit, and
- connecting, through the second switching unit, the fourth cable in turn to the second electric reference unit and to the third cable, and
- performing, with the vector network analyzer, one or more second reference measurements when the fourth cable is connected to the second electric reference unit,
- performing, with the vector network analyzer, at least one second test measurement when the fourth cable is connected to the third cable
- performing, with the vector network analyzer, at least one third reference measurement when the second cable is connected to the fourth cable via the fifth cable.

12. A method according to claim 11, wherein the second electric reference unit comprises a second short-circuit standard (S), a second open-circuit standard (O) and a second load standard (L), and performing the one or more second reference measurements comprises:
- performing one measurement when the fourth cable is connected to the second short-circuit standard (S) through the second switching unit,
- performing one measurement when the fourth cable is connected to the second open-circuit standard (O) through the second switching unit, and
- performing one measurement when the fourth cable is connected to the second load standard (L) through the second switching unit.

13. A method according to any of claims 11-12, wherein each of the first and third cables comprises an electrical connection in a printed circuit, and said printed circuit is at least partly located within the cryostat.

14. A method according to any of claims 11-13, wherein the method also comprises
- providing a second additional electric reference unit which is located outside of the cryostat,
- connecting the additional second electric reference unit to the third connection port, and
- performing, with the vector network analyzer, one or more additional second reference measurements when the additional second electric reference unit is connected to the second connection port.

15. A computer program product comprising instructions which, when executed by a computer, cause the computer to perform the method of any of claims 7-14.
